Europäisches Patentamt

European Patent Office

Office européen des brevets

(19)

(11) Veröffentlichungsnummer: **0 328 525 B1**

(12) **EUROPÄISCHE PATENTSCHRIFT**

(45) Veröffentlichungstag der Patentschrift :
12.06.91 Patentblatt 91/24

(51) Int. Cl.⁵ : **B41J 2/01**, G01R 35/00,
G05F 1/46

(21) Anmeldenummer : 87906161.2

(22) Anmeldetag : 25.09.87

(86) Internationale Anmeldenummer :
PCT/DE87/00441

(87) Internationale Veröffentlichungsnummer :
WO 88/02310 07.04.88 Gazette 88/08

(54) **ANORDNUNG ZUM ELEKTRISCHEN ABGLEICH VON IN TINTENKÖPFEN ANGEORDNETEN WANDLERELEMENTEN.**

(30) Priorität : 01.10.86 DE 3633463

(43) Veröffentlichungstag der Anmeldung :
23.08.89 Patentblatt 89/34

(45) Bekanntmachung des Hinweises auf die
Patenterteilung :
12.06.91 Patentblatt 91/24

(84) Benannte Vertragsstaaten :
CH DE FR GB IT LI NL SE

(56) Entgegenhaltungen :
DE-A- 3 340 251
US-A- 4 346 343

(73) Patentinhaber : **Siemens Aktiengesellschaft
Wittelsbacherplatz 2
W-8000 München 2 (DE)**

(72) Erfinder : **GOEPEL, Ernst
Zweigstrasse 4 b
W-8034 Germering (DE)**
Erfinder : **SCHUMANN, Werner
Wurmseestrasse 56
W-8000 München 71 (DE)**

EP 0 328 525 B1

## Beschreibung

Die Erfindung betrifft eine Anordnung gemäß dem Oberbegriff des Patentanspruches 1.

Nach dem Bubble-Jet-Prinzip arbeitende Tintendruckeinrichtungen, wie sie z.B. in der DE-A 30 12 698 beschrieben werden, enthalten Thermalwandlerelemente mit elektrischen Dünnfilm-Heizwiderständen R, die in kapillaren Tintenkanälen auf einem Substrat angeordnet sind. Beim Anlegen eines Spannungsimpulses der Höhe U und der Dauer t an einen solchen Heizwiderstand R entsteht durch die in ihm freiwerdende Stromwärme $E = (U^2/R) \cdot t$ eine Tintendampfblase, deren Druck p auf die Tinte zum Tintentröpfchenausstoß genutzt wird. Der Druck der Tintendampfblase p ist eine Funktion der freiwerdenden Stromwärme E, wobei in dieser Funktion thermodynamische, dünnfilmtechnische Einflußgrößen mit berücksichtigt werden.

Um gleiches Spritzverhalten aller Kanäle eines Kopfes sowie der Köpfe untereinander zu erhalten, sollte der Druck der Tintendampfblase p möglichst überall gleich sein. Zwar ist es möglich diese Gleichheit innerhalb der Kanäle eines Multikanalkopfes, d.h. innerhalb eines Substrates, weitgehendst zu erreichen – womit auf einen kanalweisen Abgleich verzichtet werden kann – wegen der Grenzen der Herstellbarkeit ist jedoch eine hochgenaue Reproduzierbarkeit der Dünnfilmdicken und -zusammensetzungen für verschiedene Substrate nicht möglich. Das bedeutet, die freiwerdende Stromwärme und damit der Druck in der Tintendampfblase ändert sich von Kopf zu Kopf bzw. von Fertigungslos zu Fertigungslos derart, daß eine dem Herstellungsprozeß folgende Messung und Einstellung der Tintenspritzparameter zur Herstellung eines qualitativ hochwertigen Schriftbildes unumgänglich ist.

Ein derartiger Abgleich ist im übrigen auch für die Schreibköpfe von Tintendruckeinrichtungen notwendig, die mit piezoelektrischen Wandlern arbeiten (Piezoröhrchen oder -plättchen).

Aus der Literaturstelle BJ-80 Bubble-Jet-Printer, Service Manual, Canon Q48-0101-705 Dec. 1985 ist es bekannt, bei Tintenköpfen die nach dem Thermalwandlerprinzip arbeiten, nach der Kopfherstellung in einem Spritztest die Impulsspannung U zu ermitteln, bei der sich das gewünschte Spritzverhalten des Kopfes einstellt. Diese kopfspezifische Spannung wird auf dem Tintenkopf vermerkt. Beim Einbau des Tintenschreibkopfes in ein Druckgerät wird das dortige Stromversorgungsteil mit Hilfe eines Abgleichwiderstandes, der in diesem Stromversorgungsteil angeordnet ist und eines Spannungsmeßinstrumentes eingestellt bzw. abgeglichen. Da die Lebensdauer solcher Tintenschreibköpfe begrenzt ist und während der Gesamtlebensdauer der Druckeinrichtung mehrere solcher Kopfwechsel notwendig sind, bedeutet dies einen relativ hohen Aufwand hinsichtlich der Wartung des Druckers, zumal für einen derartigen Abgleich Fachpersonal erforderlich ist.

Es ist weiterhin aus der US-A-4 346 343 bekannt eine Stromversorgung entsprechend einem auf dem zu versorgenden Schaltungsteil angebrachten Element einzustellen. Durch Anschluß des zu versorgenden Schaltungsteils an die Stromversorgung wird diese automatisch auf den für das Schaltungsteil richtigen Wert eingestellt.

Aufgabe der Erfindung ist es, eine Anordnung der eingangs genannten Art bereitzustellen mit der es möglich ist Tintenköpfe in Druckeinrichtungen auszuwechseln bzw. einzubauen, ohne daß ein gesonderter Abgleich bei jedem Kopfwechsel notwendig ist.

Diese Aufgabe wird bei einer Anordnung der eingangs genannten Art dadurch gelöst, daß der Abgleich über ein dem Schreibkopf zugeordnetes Bauelement erfolgt, dessen elektrisches Verhalten von der der Druckeinrichtung zugeordneten Stromversorgungsanordnung erfaßt wird, und daß dann die Stromversorgungsanordnung in Abhängigkeit von diesem Bauelement die Ansteuerspannung einstellt, wobei der Abgleich unabhängig von der Druckeinrichtung durch Koppelung des Schreibkopfes an eine Modellstromversorgungsanordnung erfolgt. Diese Aufgabe wird bei einer Anordnung der eingangs genannten Art dadurch gelöst, daß der Abgleich über ein dem Schreibkopf zugeordnetes Bauelement erfolgt, dessen elektrisches Verhalten von der der Druckeinrichtung zugeorneten Stromversorgungsanordnung erfaßt wird, und daß dann die Stromversorgungsanordnung in Abhängigkeit von diesem Bauelement die Ansteuerspannung einstellet, wobei der Abgleich unabhängig von der Druckeinrichtung durch Koppelung des Schreibkopfes an eine Modellstromversorgungsanordnung erfolgt.

Wird die Erfindung in Tintendruckeinrichtungen verwendet die nach dem Thermalwandlerprinzip arbeiten, so können die Wandlerelemente als auf einem Substrat angeordnete ThermalWandlerelemente ausgebildet sein, wobei der Abgleich über einen dem Substrat zugeordneten Abgleichwiderstand erfolgt.

Eine Ausführungsform der Erfindung ist in den Zeichnungen dargestellt und wird im folgenden beispielsweise näher beschrieben. Es zeigen

FIG 1 eine schematische Darstellung eines Tintenschreibkopfes nach dem Thermalwandlerprinzip beim Abgleich und

FIG 2 eine schematische Darstellung desselben Tintenschreibkopfes vor dem Einbau.

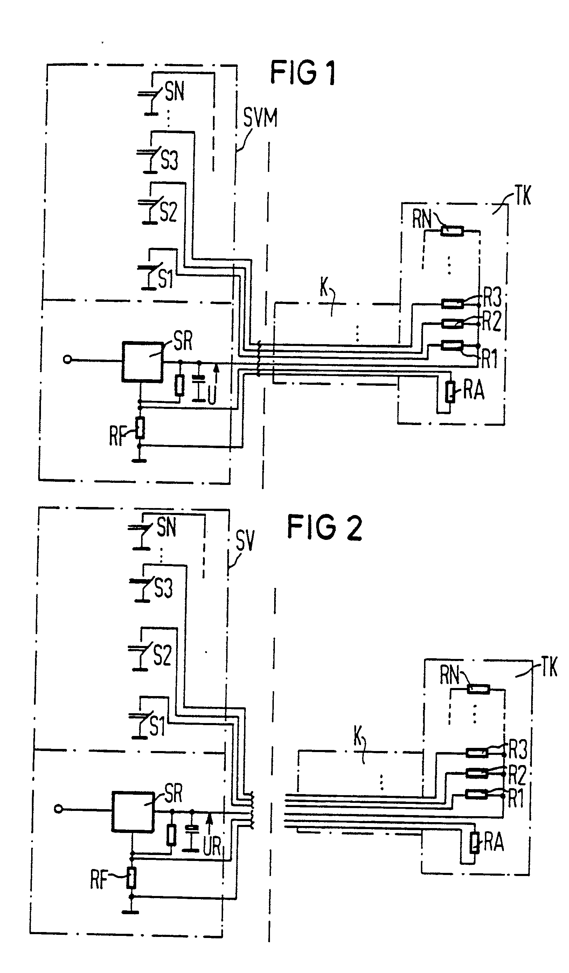

Eine hier nur schematisch dargestellte Tintendruckeinrichtung, die nach dem Thermalwandlerprinzip arbeitet, wie sie z.B. in der DE-A-30 12 698 im Detail beschrieben ist, weist einen Tintenschreibkopf TK auf, der die eigntlichen, hier nicht dargestellten Wandlerelemente enthält. Diese Wandlerelemente sind in bekannter Weise auf einem einzigen Substrat integriert und weisen die in der FIG 1 mit RI-RN bezeichneten Heizwiderstände auf. Der Schreibkopf TK wird mit Hilfe einer hier nicht dargestellten Antriebseinrichtung zeilenweise entlang eines Aufzeichnungsträgers bewegt, wobei er über ein flexibles Kabel K mit einer Stromversorgungsanordnung SV der Druckeinrichtung verbunden ist. Die Stromversorgungseinrichtung SV weist eine der Zahl der Wandlerelemente R entsprechende Anzahl von elektronischen Schaltern S1 bis SN auf, die mit der eigentlichen zeichenerzeugenden Einrichtung verbunden sind und die die Aufgabe haben, die Wandlerelemente mit ihren Heizwiderständen R1 bis RN zeichenabhängig an eine Ansteuerspannung U zu legen. Diese Ansteuerspannung U wird in bekannter Weise über einen Spannungsregler SR erzeugt.

Die erfindungsgemäße Anordnung arbeitet nun wie folgt : Nach Herstellung des eigentlichen, die Wandlerelemente mit ihren Widerständen R1 bis RN aufnehmenden Substrates wird dieses Substrat über eine entsprechende Kabelverbindung K an eine Modellstromversorgungsanordnung SVM angeschlossen. Dann wird mit Hilfe eines hier nicht dargestellten Meßinstrumentes die Ansteuerspannung U festgestellt und dann mit Hilfe eines Lasers oder anderer Einrichtungen der auf dem Substrat angeordnete Abgleichwiderstand RA so eingestellt bzw. gewählt, daß an den Heizwiderständen R1 bis RN die dem gewünschten Spritzverhalten des Tintenkopfes entsprechende Ansteuerspannung U anliegt.

Anstelle der Einstellung des Abgleichwiderstandes ist es auch möglich, einen entsprechend ausgewählten Widerstand auf der die Wandlerelemente tragenden Leiterplatte bzw. dem Substrat zu kontaktieren. Zu diesem Zwecke können entsprechende Stecker und Halterungen vorgesehen sein.

Bei entsprechend aufgebauter Stromversorgung ist es weiterhin möglich, statt Widerständen andere elektrische Bauelemente zu verwenden, die einstellbar ausgestaltet sind, z.B. Kondensatoren.

Ein so abgeglichener Kopf kann ohne zusätzlichen Abgleich in jeder Druckeinrichtung entsprechend der FIG 2 eingebaut werden, die eine der Modellstromversorgung SVM entsprechende Stromversorgung SV aufweist.

Im noch nicht angeschlossenen Zustand des Tintenkopfes TK liefert entsprechend der Fig. 2 die Stromversorgung SV mit dem zugeordnetem Referenzwiderstand RF die Leerlauf-Ansteuerspannung UR. Nach Koppelung des Tintenkopfes TK mit der Stromversorgung SV erfaßt der Spannungsregler SR durch Parallelschaltung des Abgleichwiderstandes RA mit dem Referenzwiderstand RF den voreingestellten Wert des Abgleichwiderstandes RA und stellt damit am Ausgang und damit an den Heizwiderständen R1 bis RN automatisch die kopfspezifische Ansteuerspannung U ein.

## Ansprüche

1. Anordnung zum elektrischen Abgleich von mehreren in einem Tintenschreibkopf (TK) einer Druckeinrichtung angeordneten Wandlerelementen, die über eine elektrische Schalteinrichtung (S1 bis SN) zeichenabhängig mit einer Ansteuerspannung beaufschlagbar sind, wobei in einem Funktionstest zum Ausgleich von Fertigungsschwankungen ein Abgleich der von einer Stromversorgungsanordnung (SV) gelieferten Ansteuerspannung (U) für die Wandlerelemente vorgenommen wird, **dadurch gekennzeichnet**, daß der Abgleich über ein dem Schreibkopf (TK) zugeordnetes Bauelement (RA) erfolgt, dessen elektrisches Verhalten von der der Druckeinrichtung zugeordneten Stromversorgungsanordnung (SV) erfaßt wird und daß dann die Stromversorgungsanordnung (SV) in Abhängigkeit von diesem Bauelement die Ansteuerspannung (U) einstellt, wobei der Abgleich unabhängig von der Druckeinrichtung durch Koppelung des Schreibkopfes (TK) an eine Modellstromversorgungsanordnung (SVM) erfolgt.

2. Anordnung nach Anspruch 1, **dadurch gekennzeichnet**, daß die Wandlerelemente als auf einem Substrat angeordnete Thermal-Wandlerelemente ausgebildet sind und daß der Abgleich über einen dem Substrat zugeordneten Abgleichwiderstand (RA) erfolgt.

3. Anordnung nach einem der Ansprüche 1 oder 2, **dadurch gekennzeichnet**, daß der Abgleichwiderstand (RA) auf dem Substrat integriert angeordnet ist.

4. Anordnung nach einem der Ansprüche 1 bis 3, **dadurch gekennzeichnet**, daß der Abgleichswiderstand (RA) als laserabgleichbarer Schichtwiderstand ausgebildet ist.

5. Anordnung nach einem der Ansprüche 2 bis 4, **dadurch gekennzeichnet**, daß die Stromversorgungsanordnung (SV) im Drucker einen Spannungsregler (SR) mit zugehörigem Referenzwiderstand (RF) aufweist, wobei der Referenzwiderstand (RF) bei angeschlossenem Tintendruckkopf (TK) mit dem Abgleichswiderstand (RA) elektrisch gekoppelt ist.

## Claims

1. Arrangement for the electrical balancing of a plurality of transducer elements arranged in an inking head (TK) of a printer, it being possible to supply said transducer elements in a character-dependent manner with a drive voltage via an electrical switching device (S1 to SN), balancing of the drive voltage (U) for the transducer elements, supplied by a power supply arrangement (SV), being carried out in a function test for the purpose of compensating production tolerances, characterised in that the balancing occurs by means of a component (RA) arranged in the print head (TK), the electrical behaviour of said component being detected by the power supply arrangement (SV) assigned to the printer, and in that the power supply arrangement (SV) then sets the drive voltage (U) as a function of this component, the balancing occurring independently of the printer by coupling the print head (TK) to a model power supply arrangement (SVM).

2. Arrangement according to Claim 1, characterised in that the transducer elements are constructed as thermal transducer elements arranged on a substrate, and in that the balancing occurs by means of a balancing resistor (RA) assigned to the substrate.

3. Arrangement according to one of Claims 1 or 2, characterised in that the balancing resistor (RA) is arranged integrated on the substrate.

4. Arrangement according to one of Claims 1 to 3, characterised in that the balancing resistor (RA) is constructed as a laser-tunable film resistor.

5. Arrangement according to one of Claims 2 to 4, characterised in that the power supply arrangement (SV) has a voltage controller (SR) with associated reference resistor (RF) in the printer, the reference resistor (RF) being electrically coupled to the balancing resistor (RA) when the inking head (TK) is connected.


**Revendications**

1. Dispositif pour réaliser l'équilibrage électrique de plusieurs éléments transducteurs disposés dans une tête d'écriture à encre (TK) d'un dispositif d'impression et qui peuvent être chargés, en fonction des caractères, par une tension de commande au moyen d'un dispositif de coupure électrique (S1 à SN), et dans lequel un équilibrage de la tension de commande (U) délivrée par le dispositif d'alimentation en courant (SV) pour les éléments transducteurs est réalisé lors d'un test de fonctionnement visant à compenser des variations de fabrication, caractérisé par le fait que l'équilibrage est réalisé au moyen d'un composant (RA), qui est associé à la tête d'écriture (TK) et dont le comportement électrique est détecté par le dispositif d'alimentation en courant (SV) associé au dispositif d'impression et que le dispositif d'alimentation en courant (SV) règle la tension de commande (U) en fonction de ce composant, l'équilibrage s'effectuant indépendamment du dispositif d'impression, par couplage de la tête d'écriture (TK) à un dispositif d'alimentation en courant type (SVM).

2. Dispositif suivant la revendication 1, caractérisé par le fait que les éléments transducteurs sont réalisés sous la forme d'éléments transducteurs thermiques disposés sur un substrat et que l'équilibrage est réalisé au moyen d'une résistance d'équilibrage (RA) associée au substrat.

3. Dispositif suivant la revendication 1 ou 2, caractérisé par le fait que la résistance d'équilibrage (RA) est montée de façon intégrée sur le substrat.

4. Dispositif suivant l'une des revendications 1 à 3, caractérisé par le fait que la résistance d'équilibrage (RA) est réalisée sous la forme d'une résistance à couches pouvant être équilibrée au moyen d'un laser.

5. Dispositif suivant l'une des revendications 2 à 4, caractérisé par le fait que le dispositif d'alimentation en courant (SV) situé dans l'imprimante possède un régulateur de tension (SR) auquel est associée une résistance de référence (RF), qui, lorsque la tête d'impression à encre (TK) est raccordée, est couplée électriquement à la résistance d'équilibrage (RA).

## FIG 1

## FIG 2